# FASCICULE DE BREVET EUROPEEN

(11) **EP 1 269 543 B1**
(45) Date de publication et mention de la délivrance du brevet: **13.10.2004**
(21) Numéro de dépôt: 01919428.1
(22) Date de dépôt: 04.04.2001
(51) Int. Cl.: H01L 27/146, H04N 3/15

(54) **CELLULE ACTIVE AVEC MEMOIRE ANALOGIQUE POUR UN CAPTEUR PHOTOSENSIBLE REALISE EN TECHNOLOGIE CMOS**
CMOS AKTIVER BILDSENSOR MIT ANALOGSPEICHER
ACTIVE CELL WITH ANALOG STORAGE FOR A CMOS TECHNOLOGY PHOTOSENSITIVE SENSOR

(30) Priorité: 07.04.2000 FR 0004494
(43) Date de publication de la demande: 02.01.2003
(73) Titulaire: CSEM Centre Suisse d'Electronique et de Microtechnique SA Recherche et Développement, 2007 Neuchâtel (CH)
(72) Inventeur: LAUXTERMANN, Stefan, CH-8965 Berikon (CH); ISRAEL, Georg, Paul, CH-5436 Würenlos (CH)
(74) Mandataire: Colas, Jean-Pierre
(86) Numéro de dépôt international: PCT/EP2001/003841
(87) Numéro de publication internationale: WO 2001/078150

(56) Documents cités:
- EP-A- 0 905 788
- WO-A-93/19489
- WO-A-99/26408
- WO-A-99/66560
- HUAT AW CH ET AL: "A 128 X 128-PIXEL STANDARD-CMOS IMAGE SENSOR WITH ELECTRONIC SHUTTER" IEEE JOURNAL OF SOLID-STATE CIRCUITS,US,IEEE INC. NEW YORK, vol. 31, no. 12, 1 décembre 1996 (1996-12-01), pages 1922-1930, XP000691811 ISSN: 0018-9200 cité dans la demande
- PATENT ABSTRACTS OF JAPAN vol. 1999, no. 03, 31 mars 1999 (1999-03-31) -& JP 10 322599 A (TOSHIBA CORP), 4 décembre 1998 (1998-12-04)

## Description

La présente invention est relative à une cellule active pour un capteur photosensible réalisé en technologie CMOS et comprenant une pluralité de ces cellules agencées selon une matrice adressable dans laquelle les cellules subissent des cycles de travail successifs consistant, au moins, en une phase d'exposition pour détecter la quantité de lumière qui les frappe, puis en une phase d'exploration au cours de laquelle l'information de luminance due à cette quantité de lumière est extraite de la cellule.

Une cellule connue de ce type est décrite dans un article de Huat et al, paru dans la revue IEEE Journal of Solid State Circuits, volume 11, N°12 de décembre 1996.

Cette cellule connue comprend
- un élément photosensible,
- des premiers moyens adressables pour activer/désactiver cet élément photosensible après ladite phase d'exposition,
- des deuxièmes moyens adressables pour, au cours de ladite phase d'exploration, extraire de la cellule le signal de luminance engendrée par ledit élément photosensible,
- des troisièmes moyens adressables pour transférer ledit signal de luminance dudit élément photosensible auxdits deuxièmes moyens adressables;
- des moyens de mémoire pour conserver ledit signal de luminance entre la phase d'exposition et l'instant où ladite cellule est adressée pour l'activation desdits deuxièmes moyens adressables; et
- des quatrièmes moyens adressables pour décharger lesdits moyens de mémoire après la phase de lecture de la cellule, ledit élément photosensible et lesdits premiers, deuxièmes et troisièmes moyens adressables étant implémentés sous la forme de composants semi-conducteurs intégrés dans un substrat avec des types de conductivité prédéterminés.

Une telle cellule présente une fonction d'obturation qui permet d'annuler momentanément l'influence de la lumière incidente pendant le temps d'attente s'écoulant entre la phase d'exposition et l'instant où la cellule est lue dans l'ordre d'adressage du réseau dans lequel elle est incorporée. Pour réaliser cette fonction, le signal de luminance détecté pendant la phase d'exposition est intégré dans les moyens de mémoire qui peuvent être implémentés sous la forme d'une capacité faisant partie de la cellule. Le signal de luminance étant dans ce type de cellule CMOS de nature analogique, il est important que la capacité ainsi utilisée puisse conserver la charge correspondant à ce signal sans distorsion, ni perte pendant tout le temps d'attente jusqu'à la lecture de la cellule. Par conséquent, pendant ce temps, la capacité doit être isolée le mieux possible du reste de la cellule pour éviter toute fuite de sa charge. A cet effet, dans la cellule connue de l'article précité, les moyens de mémorisation implémentés sous la forme d'une capacité sont découplés de l'élément photosensible par les troisièmes moyens adressables dès la fin de la phase d'exposition.

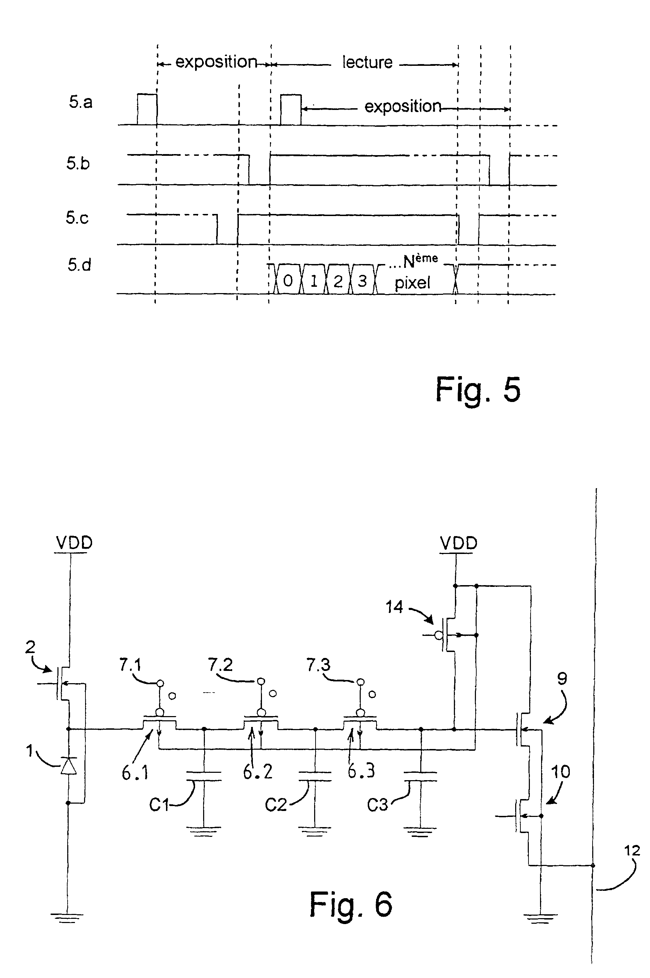

L'implémentation de la cellule connue (figure 4 de l'article) consiste à utiliser des transistors d'un même type de conductivité (en l'occurrence le type p), l'élément photosensible étant une région de diffusion p⁺. Les moyens de transfert, appelés ici "obturateur" (shutter en anglais), sont réalisés sous la forme d'un transistor de type p dont la source est une région de diffusion de type p⁺ à laquelle est raccordé un noeud sur lequel peuvent être accumulées les charges intégrées au cours de la phase d'exposition, par exemple en vertu de la capacité parasite que présente par inhérence ce noeud. Cependant, l'implantation de source du transistor de transfert ou d'obturation peut aussi accumuler des charges et les dévier vers le substrat de la cellule ce dont il résulte une distorsion du signal de luminance réellement accumulé sur le noeud et extrait ensuite de la cellule, lorsque celle-ci est adressée pour la lecture. Un autre exemple de cellule connue présentant l'inconvénient d'intégrer des charges parasites peut être trouvé dans le brevet américain USP 5'900'623.

Pour réduire l'influence de l'accumulation parasitaire des charges dans l'implantation de source du transistor d'obturation, il serait possible d'augmenter la capacité du noeud d'accumulation, mais ceci nécessiterait l'implémentation d'une région capacitive raccordée au noeud. Cette solution présenterait l'inconvénient de demander une place trop considérable sur le substrat réduisant du même coup le coefficient de remplissage de celui-ci. En outre, si l'influence de l'accumulation parasitaire des charges était ainsi réduite, elle n'en resterait pas moins présente et contribuerait néanmoins à distordre le signal de luminance finalement extrait de la cellule au moment de la lecture.

L'invention a pour but d'apporter une solution alternative à ce problème qui permette après la phase d'exposition d'isoler quasi entièrement le noeud d'accumulation de charges du reste du circuit sans trop augmenter l'encombrement de la cellule et de réduire quasiment à néant l'accumulation parasitaire. Un avantage résultant de l'invention réside dans le fait que les caractéristiques spectrales de l'élément photosensible ne sont pas altérées.

L'invention a donc pour objet une cellule telle que définie ci-dessus qui est caractérisée en ce que lesdits troisièmes- et quatrièmes moyens adressables sont placés dans au moins un caisson ménagé dans le substrat, ledit au moins un caisson présentant un premier type de conductivité opposé à celui du substrat, qui présente un second type de conductivité et dans lequel est réalisé l'élément photosensible.

Grâce à ces caractéristiques, les porteurs de charges qui, lors de l'éclairement de la cellule auraient tendance à migrer vers les moyens de mémoire sont arrêtés à la jonction entre le substrat et le caisson dans lequel sont placés lesdits troisièmes moyens adressables. Elles ne peuvent ainsi atteindre le noeud sur lequel s'accumulent les charges représentant le signal de luminance utile.

Selon d'autres caractéristiques avantageuses de l'invention:
- ledit premier type de conductivité est le type p et le second type de conductivité est le type n;
- ledit premier type de conductivité est le type n et le second type de conductivité est le type p;
- une région de diffusion est implantée dans ledit caisson et connectée à une source de tension de polarisation de préférence réglable, cette région ayant le second type de conductivité;
- lesdits quatrièmes moyens adressables sont implantés dans ledit caisson;
- lesdits troisièmes moyens consistent en une pluralité de transistors connectés en série et commandés, chacun, par une tension fixe.

D'autres caractéristiques et avantages de la présente invention apparaîtront au cours de la description qui va suivre, donnée uniquement à titre d'exemple et faite en se référant aux dessins annexés sur lesquels:
- la figure 1 est un schéma d'une cellule pour capteur photosensible selon l'invention, réalisée avec une technologie à substrat p;
- la figure 2 montre schématiquement un exemple d'implémentation d'une cellule représentée sur la figure 1;
- la figure 3 est un schéma d'une cellule selon l'invention réalisée avec une technologie à substrat n;
- la figure 4 est un exemple d'implémentation de la cellule de la figure 3;
- la figure 5 est un diagramme des signaux de la cellule de la figure 3; et
- la figure 6 est encore un autre exemple de réalisation d'une cellule selon l'invention.

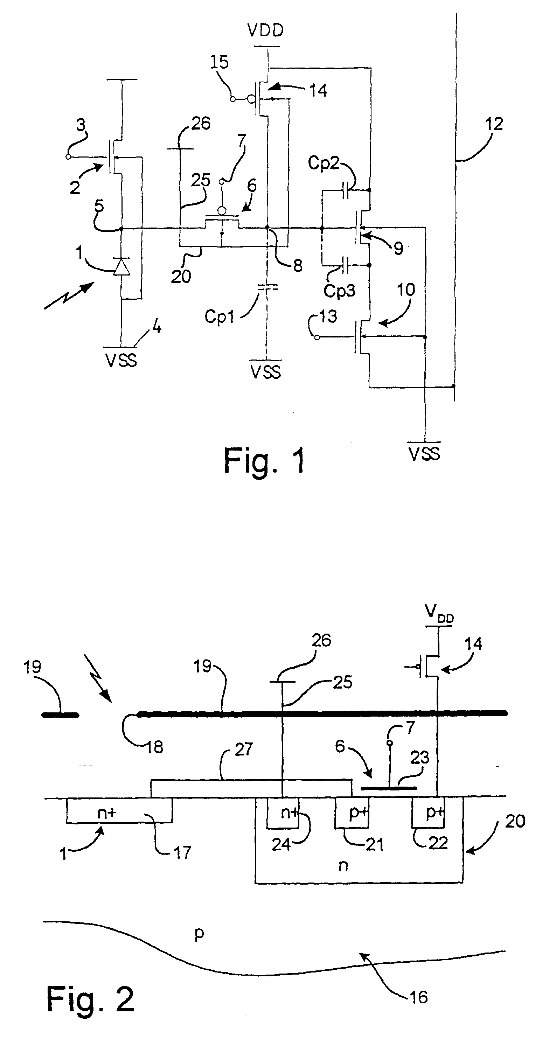

Les cellules représentées sur les figures sont destinées à faire partie d'un capteur photosensible réalisé selon la technologie CMOS sur un substrat semiconducteur. Ce substrat comporte une matrice d'un grand nombre de cellules adressables organisées d'une façon connue en soi, par exemple selon le schéma de la figure 1 de l'article précité.

On rappelle brièvement le principe de fonctionnement, également connu en soi, d'une telle matrice.

La matrice subit des cycles successifs d'observation d'une scène par exemple, chaque cycle comportant une phase d'exposition du capteur à la lumière renvoyée par la scène, suivie d'une phase d'exploitation ou d'acquisition au cours de laquelle les cellules du capteur sont lues en séquence par adressage matriciel. Ainsi, la matrice peut délivrer une succession de signaux de rangée composés chacun d'une tension variable divisée en échantillons représentant chacun le signal de luminance d'une cellule de la rangée concernée.

Dès lors, on comprend que le signal de luminance engendré dans chaque cellule pendant la phase d'exposition doit être mémorisé jusqu'à ce que l'adressage de la matrice désigne la cellule concernée pour la lecture, mémorisation qui est réalisée par accumulation de charges dans une capacité présente dans la cellule.

En se référant maintenant plus particulièrement à la figure 1, on voit qu'une cellule selon l'invention comprend une diode photosensible 1 connectée en série avec un transistor 2 de type n qui constitue les premiers moyens adressables de la cellule et dont la grille est connectée pour recevoir un signal de désactivation de la photodiode 1 d'une borne de commande 3. La diode 1 et le transistor 2 sont connectés entre la masse et une tension d'alimentation (Vₛₛ) de la diode appliquée sur une borne d'alimentation 4. Le noeud 5 entre la diode 1 et le transistor 2 est connecté à un transistor d'obturation 6 qui matérialise les troisièmes moyens adressables de la cellule. La grille de ce transistor 6 est connectée à une borne de commande d'obturation 7 de la cellule. Lorsqu'il est conducteur, ce transistor d'obturation transfère, vers le noeud 8 d'accumulation de charges, un signal correspondant à la quantité de charges apparaissant sur le noeud 5.

Le noeud 8 d'accumulation de charges est relié à la grille d'un transistor 9 faisant office de tampon et d'amplificateur, ce transistor 9 étant monté de manière à pouvoir convertir le signal de luminance utile engendré par la diode 1 et apparaissant sous forme d'une tension sur le noeud 8 en un courant pouvant être évacué de la cellule pendant la phase de lecture. Le transistor 9 est connecté en série avec un transistor 10 de commande de lecture entre une borne d'alimentation (V_{DD}) 11 et une ligne de sortie 12 qui dans la matrice de cellules est une ligne de colonne. La grille du transistor 10 est connectée à une borne de commande de lecture 13. Les transistors 9 et 10 matérialisent les seconds moyens adressables de la cellule.

Le noeud 8 est connecté à plusieurs capacités parasites cp1, cp2 et cp3. La capacité cp1 qui est la plus importante se situe entre le noeud 8 et la masse, tandis que les- deux autres capacités cp2 et cp3 connectent le noeud 8 de part et d'autre du transistor 9. Dans l'exemple représenté, ces capacités parasites matérialisent les moyens de mémoire de la cellule, leur valeur totale pouvant en général suffire pour la conservation de la charge après la phase d'exposition jusqu'à -la lecture de la cellule. Si tel n'était pas le cas dans une implémentation donnée, on pourrait envisager d'intégrer avec le circuit de la cellule une capacité dimensionnée convenablement et raccordée par exemple entre le noeud 8 et la masse.

Le noeud 8 est également connecté à un transistor de remise à zéro 14 (quatrièmes moyens) qui est destiné à maintenir déchargé le noeud 8 entre chaque lecture et la phase d'exposition suivante de la cellule. Ce transistor 14 est commandé à cet effet par un signal appliqué sur une borne 15 connectée à sa grille. Le trajet drain-source de ce transistor 14 est relié entre le noeud 8 et la borne V_{DD}.

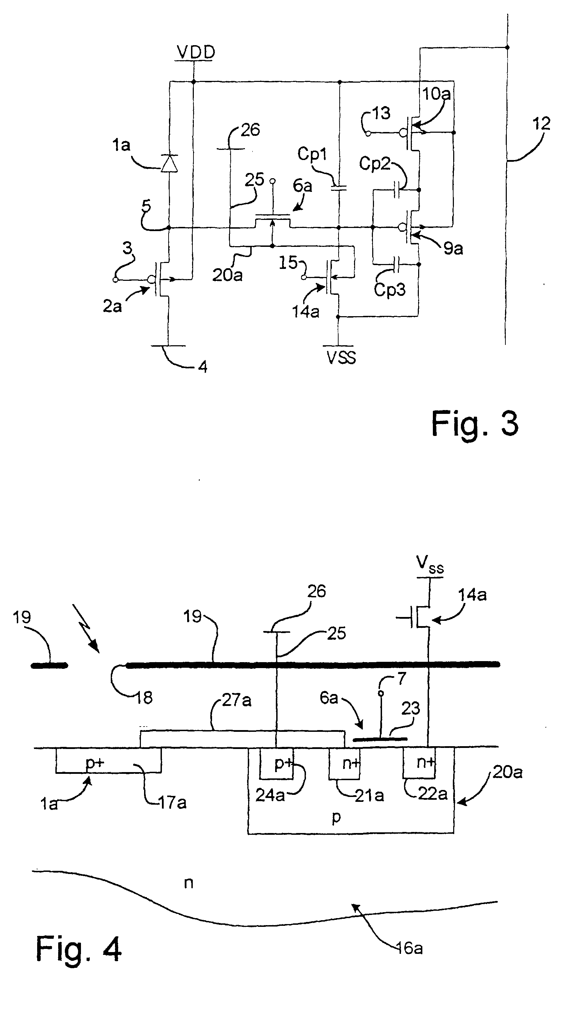

L'implémentation de la cellule de la figure 1 est représentée partiellement et schématiquement sur la figure 2. La cellule est intégrée sur un substrat 16 de type p avec une pluralité d'autres cellules (non représentées), toutes identiques, en une matrice qui comporte également toutes les connexions d'adressage et d'alimentation, par exemple selon le schéma de la figure 4 de l'article précité.

Plus précisément, la diode 1 est constituée par une région n⁺ 17 réalisée dans le substrat et qui est placée derrière une ouverture 18 d'un écran 19 destiné à réduire la libération de porteurs de charges dans les autres composants de la cellule par la lumière incidente. Cet écran 19 peut être une couche finale déposée par-dessus l'ensemble des cellules et présentant une ouverture 18 en face de chaque région 17. De manière plus générale l'élément photosensible 1 est une région apte à collecter les électrons engendrés par la lumière et qui peut être une zone dopée n⁺ ou n⁻ ou encore une "photogate".

Selon une caractéristique essentielle de l'invention, le transistor d'obturation 6 et le transistor de remise à zéro 14 sont placés dans un caisson 20 d'un type de conductivité opposé à celui du substrat 16. Les deux transistors 6 et 14 peuvent partager le même caisson ou être réalisés dans deux caissons séparés mais de même type de conductivité. Dans l'exemple, ce type de conductivité est n. Dans le caisson 20 sont ménagées deux régions de diffusion p⁺ 21 et 22 de même type de conductivité que celui du substrat qui forment, avec une grille 23 prévue entre elles, le transistor d'obturation 6 (le transistor 14 n'est pas représenté à la figure 2). Il est prévu également une troisième région de diffusion n⁺ 24 d'un type de conductivité opposé à celui du substrat et située à l'écart des régions de diffusion p⁺ 21 et 22. Cette troisième région 24 sert à appliquer une tension de polarisation au caisson 20 par l'intermédiaire d'une connexion 25 et d'une borne d'alimentation 26. Sur la figure 1, le caisson 20 est symbolisé par un conducteur portant la même référence que sur la figure 2.

Dans l'exemple, les régions de diffusion 21 et 22 sont de type p⁺ et la région de diffusion 24 est de type n⁺. On notera également que le transistor 14 est de type p. Il peut être réalisé dans le caisson 20 ou dans un autre caisson, devant dans l'exemple être de type n prévu ailleurs dans le substrat 16. On notera également que le noeud 5 est relié- au- transistor 6 par l'intermédiaire d'une connexion 27 extérieure au substrat 16.

Lorsque de la lumière frappe la matrice de cellules dans laquelle est incorporée la cellule qui vient d'être décrite, des électrons libérés à l'extérieur de la zone d'appauvrissement de la photodiode 1 migrent à travers le substrat 16 jusqu'à ce qu'ils soient piégés par la région 17 de la diode 1 ou par le caisson 20 dans lequel est placée la région p⁺, cette dernière formant en fait le noeud 8. Cependant, comme le caisson 20 est polarisé à une tension fixe qui lui est appliquée par l'intermédiaire de la borne 26, la quantité de charges s'accumulant dans le noeud 8 n'est pas modifiée par ces charges parasitaires.

Le temps pendant lequel les charges utiles restent conservées sur le noeud 8 dépend essentiellement du courant de fuite s'écoulant dans la diode formée entre la région p⁺ 22 et le caisson 20 de type n, diode dont les caractéristiques dépendent de la technologie utilisée. C'est pourquoi une caractéristique avantageuse de l'invention consiste à prévoir la possibilité de polariser au choix du concepteur, le caisson 20 par l'intermédiaire de la connexion 25 et de la borne 26 afin de pouvoir ajuster au mieux, par réglage de la tension de polarisation, le temps de conservation des charges avant qu'une lecture de la cellule doive être effectuée.

Les figures 3 et 4 représentent un mode de réalisation selon une forme duale de celle de la figure 1 en ce qui concerne les types de conductivité utilisés. Sur ces figures, les composants de même fonction mais de type de conductivité opposé à celui qu'ils ont dans les figures 1 et 2, ont été désignés par la même référence munie du suffixe "a".

Il est à noter que les fonctions exercées par les transistors 9 et 10 ou 9a, 10a peuvent être mises en oeuvre également par des moyens équivalents situés à l'extérieur de la puce dans laquelle est réalisée la matrice composée des cellules selon l'invention. Dans ce cas, bien entendu les transistors correspondants ne sont pas prévus dans la cellule elle-même.

La structure de la cellule selon l'invention offre également la possibilité d'ajourner sa lecture jusqu'à un moment considéré comme approprié par le concepteur en jouant notamment sur la tension du caisson 20 ou 20a. Ainsi, on peut notamment assurer l'élimination du bruit thermique et du bruit grenaille (ou "shot noise" en anglais) du courant de fuite de diode, qui risquent d'affecter le signal utile obtenu.

La figure 5 montre un diagramme des signaux de commande de la cellule de la figure 1. Le signal de commande du transistor 2 est montré en (a); il détermine le temps d'exposition. En (b) est montré le signal de commande du transistor d'obturation 6. Le signal de commande du transistor de remise à zéro 14 est montré en (c), tandis qu'en (d) apparaît la succession des valeurs lues sur les différentes cellules (ou "pixels") du capteur.

La figure 6 montre encore un autre exemple de réalisation de la cellule selon l'invention. Selon cette variante, le transistor d'obturation 6 est constitué en fait d'une pluralité de transistors (6.1 à 6.3), chacun étant associé à des moyens de mémorisation (C1 à C3) et étant commandé par une tension appliquée sur leur grille (7.1 à 7.3).

## Revendications

1. Cellule active pour un capteur photosensible réalisé en technologie CMOS et comprenant une pluralité de ces cellules agencées selon une matrice adressable dans laquelle les cellules subissent des cycles de travail successifs consistant, au moins, en une phase d'exposition pour détecter la quantité de lumière qui les frappe, puis en une phase d'exploration au cours de laquelle l'information de luminance due à cette quantité de lumière est extraite de la cellule, cette cellule comprenant
- un élément photosensible (1),
- des premiers moyens adressables (2) pour activer/désactiver cet élément photosensible après ladite phase d'exposition,
- des deuxièmes moyens adressables (9, 10) pour, au cours de ladite phase d'exploration, extraire de la cellule le signal de luminance engendré par ledit élément photosensible (1),
- des troisièmes moyens adressables (6) pour transférer ledit signal de luminance dudit élément photosensible (1) auxdits deuxièmes moyens adressables (8, 10);
- des moyens de mémoire (cp1 à cp3) pour conserver ledit signal de luminance entre la phase d'exposition et l'instant où ladite cellule est adressée pour l'activation desdits deuxièmes moyens adressables (9, 10), et
- des quatrièmes moyens adressables pour décharger lesdits moyens de mémoire après la phase de lecture de la cellule, ledit élément photosensible et lesdits premiers, seconds, troisièmes et quatrièmes moyens adressables étant implémentés sous la forme de composants semi-conducteurs intégrés dans un substrat (16) avec des types de conductivité prédéterminés, lesdits troisièmes et quatrièmes moyens adressables étant placés dans au moins un caisson (20) ménagé dans le substrat (16), ledit au moins un caisson présentant un premier type de conductivité opposé à celui du substrat, qui présente un second type de conductivité et dans lequel est réalisé l'élément photosensible (1).

2. Cellule suivant la revendication 1, **caractérisée en ce que** ledit premier type de conductivité est le type p et le second type de conductivité est le type n.

3. Cellule suivant la revendication 1, **caractérisée en ce que** ledit premier type de conductivité est le type n et le second type de conductivité est le type p.

4. Cellule suivant l'une quelconque des revendications précédentes, **caractérisée en ce qu'**une région de diffusion (24) est implantée dans ledit caisson (20) et connectée à une source de tension de polarisation (26), de préférence réglable, cette région ayant le second type de conductivité.

5. Cellule suivant la revendication 4, **caractérisée en ce que** lesdits quatrièmes moyens adressables (14) sont implantés dans ledit caisson (20).

6. Cellule selon l'une quelconque des revendications 1 à 5, **caractérisée en ce que** lesdits troisièmes moyens consistent en une pluralité de transistors (6.1 à 6.3) connectés en série et commandés, chacun, par une tension fixe.

## Patentansprüche

1. Aktive Zelle für einen fotoempfindlichen Aufnehmer, der in CMOS-Technik ausgeführt ist und mehrere dieser Zellen aufweist, welche in einer adressierbaren Matrix angeordnet sind, in welchen die Zellen aufeinanderfolgenden Arbeitszyklen ausgesetzt sind, welche mindestens aus einer Belichtungsphase zum Detektieren der auf sie auftreffenden Lichtmenge und dann einer Auswertungsphase bestehen, in deren Verlauf die Leuchtdichteinformation aufgrund dieser Lichtmenge aus der Zelle ausgelesen wird, wobei diese Zelle aufweist:
- ein fotoempfindliches Element (1),
- erste adressierbare Mittel (2) zum Aktivieren/Desaktivieren dieses fotoempfindlichen Elementes nach der Belichtungsphase,
- zweite adressierbare Mittel (9, 10) zum Auslesen des von diesem fotoempfindlichen Element (1) erzeugten Leuchtdichtesignals aus der Zelle im Verlauf der Auswertungsphase,
- dritte adressierbare Mittel (6) zum Übertragen des Leuchtdichtesignals des fotoempfindlichen Elementes (1) auf die zweiten adressierbaren Mittel (8, 10),
- Speichermittel (cp1 bis cp3) zum Erhalten des Leuchtdichtesignals zwischen der Belichtungsphase und dem Augenblick, in dem die Zelle zum Aktivieren der zweiten adressierbaren Mittel (9, 10) adressiert wird, und
- vierte adressierbare Mittel zum Entladen der Speichermittel nach der Phase des Auslesens der Zelle, wobei das fotoempfindliche Element und die ersten, zweiten, dritten und vierten adressierbaren Mittel in Form von in ein Substrat (16) integrierten Halbleiterbauelementen mit vorgegebenen Leitfähigkeitstypen implementiert sind, wobei die dritten und vierten adressierbaren Mittel in mindestens einem in das Substrat (16) eingearbeitetes Gehäuse (20) angeordnet sind, wobei das mindestens eine Gehäuse einen ersten Leitfähigkeitstyp aufweist, der zu dem des Substrats entgegengesetzt ist, welches einen zweiten Leitfähigkeitstyp aufweist und in dem das fotoempfindliche Element (1) vorgesehen ist.

2. Zelle nach Anspruch 1, **dadurch gekennzeichnet, dass** der erste Leitfähigkeitstyp der p-Typ und der zweite Leitfähigkeitstyp der n-Typ ist.

3. Zelle nach Anspruch 1, **dadurch gekennzeichnet, dass** der erste Leitfähigkeitstyp der n-Typ und der zweite Leitfähigkeitstyp der p-Typ ist.

4. Zelle nach einem der vorhergehenden Ansprüche, **dadurch gekennzeichnet, dass** ein Diffusionsbereich (24) in dem Gehäuse (20) vorgesehen und mit einer vorzugsweise regelbaren Polarisationsspannungsquelle (26) verbunden ist, wobei dieser Bereich den zweiten Leitfähigkeitstyp hat.

5. Zelle nach Anspruch 4, **dadurch gekennzeichnet, dass** die vierten adressierbaren Mittel (14) in dem Gehäuse (20) vorgesehen sind.

6. Zelle nach einem der Ansprüche 1 bis 5, **dadurch gekennzeichnet, dass** die dritten Mittel aus einer Anzahl Transistoren (6.1 bis 6.3) bestehen, die in Reihe geschaltet und jeweils durch eine festgelegte Spannung gesteuert sind.

## Claims

1. An active cell for a CMOS technology photosensitive sensor comprising a plurality of said cells arranged in an addressable matrix in which the cells undergo successive working cycles consisting at least in an exposure phase for detecting the quantity of light that impinges on them followed by a scanning phase during which the luminance information due to that quantity of light is extracted from the cell, said cells comprising:
- a photosensitive element (1),
- first addressable means (2) for activating/deactivating said photosensitive element after said exposure phase,
- second addressable means (9, 10) for extracting from the cell, during said scanning phase, the luminance signal generated by said photosensitive element (1),
- third addressable means (6) for transferring said luminance signal from said photosensitive element (1) to said second addressable means (8, 10);
- memory means (cp1 to cp3) for retaining said luminance signal between the exposure phase and the time at which said cell is addressed to activate said second addressable means (9, 10), and
- fourth addressable means for discharging said memory means after the cell reading phase, said photosensitive element and said first, second, third and fourth addressable means being implemented in the form of semiconductor components integrated into a substrate (16) with predetermined conductivity types, said third and fourth addressable means being placed in at least one well (20) formed in the substrate (16), said at least one well having a first conductivity type opposite that of the substrate, which has a second conductivity type and in which the photosensitive element (1) is produced.

2. A cell according to claim 1, **characterized in that** said first conductivity type is the p-type and the second conductivity type is the n-type.

3. A cell according to claim 1, **characterized in that** said first conductivity type is the n-type and the second conductivity type is the p-type.

4. A cell according to claim 1, **characterized in that** a diffusion region (24) is implanted in said well (20) and connected to a bias voltage source (26), which is preferably adjustable, said region having the second conductivity type.

5. A cell according to claim 4, **characterized in that** said fourth addressable means (14) are implanted in said well (20).

6. A cell according to claims 1, **characterized in that** said third means consist of a plurality of transistors (6.1 to 6.3) connected in series and each controlled by a fixed voltage.
